# EUROPEAN PATENT SPECIFICATION

(11) **EP 2 287 367 B1**
(45) Date of publication and mention of the grant of the patent: **13.01.2016**
(21) Application number: 09746653.6
(22) Date of filing: 14.05.2009
(51) Int. Cl.: C30B 23/02, C30B 29/36, C30B 29/38, C30B 23/00, C30B 29/40

(54) **SINGLE CRYSTAL MANUFACTURING DEVICE AND MANUFACTURING METHOD**
VORRICHTUNG UND VERFAHREN ZUR HERSTELLUNG EINES EINKRISTALLS
DISPOSITIF ET PROCÉDÉ DE FABRICATION DE MONOCRISTAUX

(30) Priority: 16.05.2008 JP 2008129187
(43) Date of publication of application: 23.02.2011
(73) Proprietor: Bridgestone Corporation, Tokyo 104-8340 (JP)
(72) Inventor: MOTOYAMA, Tsuyoshi, Kodaira-shi Tokyo 187-8531 (JP); KONDO, Daisuke, Kodaira-shi Tokyo 187-8531 (JP)
(74) Representative: Oxley, Robin John George
(86) International application number: PCT/JP2009/059013
(87) International publication number: WO 2009/139447

(56) References cited:
- JP-A- 2002 060 297
- JP-A- 2002 060 297
- JP-A- 2004 224 663

## Description

### TECHNICAL FIELD

The present invention relates to a single crystal manufacturing device and a manufacturing method.

### BACKGROUND ART

Patent Documents 1 and 2 disclose methods for manufacturing a silicon carbide single crystal. In these manufacturing methods, one guide member is provided inside a crucible. This guide member guides a sublimed gas of a silicon carbide raw material to a silicon carbide seed crystal. Then, a silicon carbide single crystal grows on a surface of the guide member (specifically, a surface thereof facing the silicon carbide raw material).

### PRIOR ART DOCUMENTS

### PATENT DOCUMENTS

Patent Document 1: Japanese Patent Application Publication No. 2002-60297
Patent Document 2: Japanese Patent Application Publication No. 2004-224663

### SUMMARY OF THE INVENTION

In these manufacturing methods, the silicon carbide single crystal growing on an inside surface of the guide member faces the silicon carbide raw material. Accordingly, both the silicon carbide raw material and the silicon carbide single crystal are susceptible to the effect of heat radiation from each other. The silicon carbide single crystal is likely to absorb heat from the silicon carbide raw material. Therefore, there arises a problem of a difficulty in controlling the temperature of the silicon carbide raw material.

As the silicon carbide single crystal grows, a contact area between the silicon carbide single crystal and the guide member increases. As the contact area increases, the effect of a thermal stress generated between the silicon carbide single crystal and the guide member becomes larger. Accordingly, there is a risk that a crack may occur in the silicon carbide single crystal. In addition, as the contact area increases, heat of the guide member is likely to be taken away by the silicon carbide single crystal. Accordingly, there also arises a problem of the temperature of the guide member being likely to be lowered. When the temperature of the guide member goes down, there arises a problem that, for example, silicon carbide polycrystal is likely to attach to the guide member.

A center portion of a silicon carbide single crystal (a part extending vertically downward from the silicon carbide seed crystal) will be used as a product. Accordingly, in order to prevent a polycrystal from entering this center portion, a guide member needs to be made wide in the lateral direction. However, when the guide member is made wider in the lateral direction, a silicon carbide single crystal ends up growing along the guide member. Therefore, there arises a problem that the center portion to be used as a product is smaller than a portion which will not be used as a product.

The present invention has been carried out to solve the problems described above, and an object thereof is to provide a single crystal manufacturing method and manufacturing device which are capable of improving the quality of a single crystal and facilitating the growth of a center portion of the single crystal by making the temperature control of a raw material for single crystal growth easier than in the past.

The gist thereof is a single crystal manufacturing device, comprising: a container member configured to house a raw material for single crystal growth and a seed crystal for single crystal growth in such a manner that the raw material for single crystal growth and the seed crystal for single crystal growth face each other, the raw material for single crystal growth being used as a single crystal raw material, a sublimed gas produced by sublimation of the raw material for single crystal growth recrystallizing on the seed crystal for single crystal growth, and a plurality of guide members provided inside the container member, wherein the guide members each have an opening portion formed therein at a position corresponding to the seed crystal for single crystal growth, and are provided at intervals between the raw material for single crystal growth and the seed crystal for single crystal growth.

The gist thereof is a single crystal manufacturing method, comprising the steps of housing a raw material for single crystal growth and a seed crystal for single crystal growth at respective positions facing each other inside a container member, and arranging guide members, which each have an opening portion formed therein at a position corresponding to the seed crystal for single crystal growth, at intervals between the raw material for single crystal growth and the seed crystal for single crystal growth, and subliming the raw material for single crystal growth, guiding a sublimed gas of the raw material for single crystal growth by the plurality of guide members to the seed crystal for single crystal growth, and growing a single crystal on surfaces of the plurality of guide members.

In the single crystal manufacturing device and manufacturing method according to the present invention, the multiple guide members are provided at intervals. Accordingly, a single crystal grown between the guide members is not exposed to the raw material for single crystal growth. On the other hand, a conventional manufacturing method includes only one guide member. Accordingly, the area of a single crystal exposed to the raw material for single crystal growth (hereinafter, also referred to as an "exposure area of single crystal") becomes larger as the single crystal grows.

Thus, with the single crystal manufacturing device and manufacturing method according to the present invention, the exposure area of single crystal can be made smaller than that in the conventional manufacturing method. Accordingly, the effects of heat radiation on the raw material for single crystal growth and the single crystal from each other can be smaller. Thus, with the single crystal manufacturing device and manufacturing method according to the present invention, the temperature control on the raw material for single crystal growth can be performed more easily than in the past.

Specifically, the temperature of the raw material for single crystal growth can be easily maintained high. Further, with the multiple guide members provided at intervals, the heat insulating effect inside the container member is improved. In other words, the inside of the container member can be easily maintained at a target temperature.

Further, in the single crystal manufacturing device and manufacturing method according to the present invention, once reaching the next guide member after growing on a surface of a first guide member, a single crystal hardly grows on the surface of the first guide member but grows on a surface of the next guide member. Accordingly, the contact area between the single crystal and each of the guide members can be suppressed to a certain value or below. In addition, this value can be made smaller by narrowing the intervals between the guide members.

On the other hand, in the conventional manufacturing method, there is only one guide member; therefore, the contact area between the single crystal and the guide member becomes larger as the single crystal grows. With the single crystal manufacturing device and manufacturing method according to the present invention, the contact area between the single crystal and each of the guide members can be made smaller compare to that by the conventional manufacturing method. Accordingly, it is possible to prevent growth in a portion other than the center portion of the single crystal as well as to allow the center portion of the single crystal, which is to be used as a product, to grow large.

Further, with the single crystal manufacturing device and manufacturing method according to the present invention, the effect of the heat stress generated between the single crystal and each of the guide members can be made smaller; therefore, the possibility of a crack occurring in the single crystal can be reduced.

Further, with the single crystal manufacturing device and manufacturing method according to the present invention, the contact area between the single crystal and each of the guide members can be made smaller than in the conventional manufacturing method. Accordingly, the growth of the center portion to be used as a product can be facilitated.

Thus, with the manufacturing method according to the present embodiment, the temperature control on the raw material for single crystal growth is easier than in the conventional manufacturing method. Accordingly, the quality of single crystal can be improved. Further, the growth of a center portion of a single crystal can be facilitated.

### BRIEF DESCRIPTION OF THE DRAWINGS

[Fig. 1] Fig. 1 is a schematic view illustrating a silicon carbide single crystal manufacturing device according to an embodiment of the present invention.
[Fig. 2] Fig. 2 is a flowchart illustrating a silicon carbide single crystal manufacturing method according to the embodiment of the present invention.
[Fig. 3] Fig. 3 is a schematic view illustrating how a silicon carbide single crystal grows.
[Fig. 4] Fig. 4 is a schematic view illustrating how a silicon carbide single crystal grows.
[Fig. 5] Fig. 5 is a schematic view illustrating a silicon carbide single crystal grown in the silicon carbide single crystal manufacturing method according to the embodiment of the present invention.
[Fig. 6] Fig. 6 is a schematic view illustrating a silicon carbide single crystal grown in a conventional manufacturing method.
[Fig. 7] Fig. 7 is a schematic view illustrating a modification example of the embodiment of the present invention.
[Fig. 8] Fig. 8 is a schematic view illustrating another modification example of the embodiment of the present invention.
[Fig. 9] Fig. 9 is a schematic view illustrating still another modification example of the embodiment of the present invention.
[Fig. 10] Fig. 10 is a schematic view illustrating still another modification example of the embodiment of the present invention.
[Fig. 11] Fig. 11 is a schematic view illustrating still another modification example of the embodiment of the present invention.
[Fig. 12] Fig. 12 is a schematic view illustrating still another modification example of the embodiment of the present invention.

### MODES FOR CARRYING OUT THE INVENTION

Hereinafter, a silicon carbide single crystal manufacturing device and manufacturing method thereof as an embodiment of the present invention will be described.

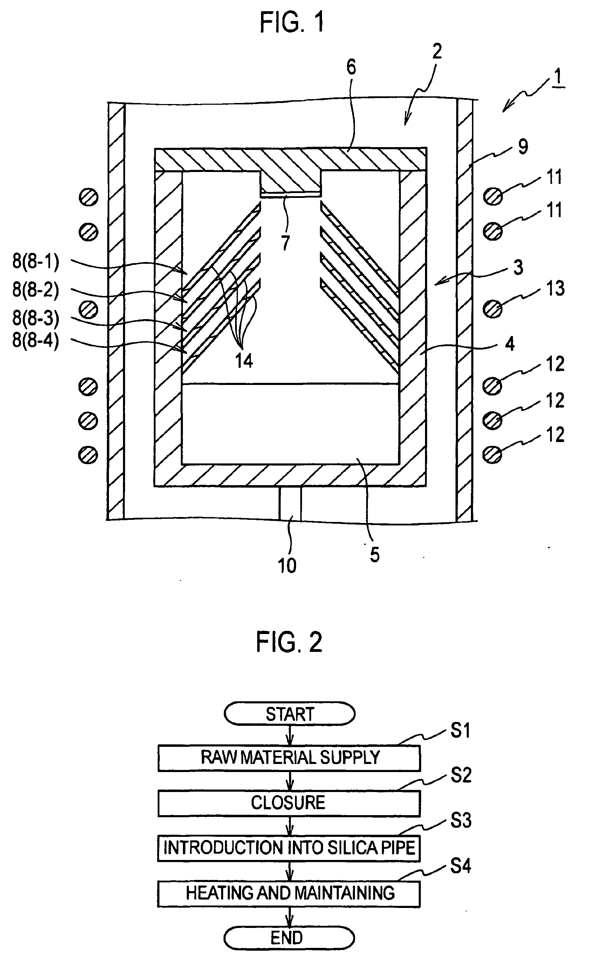

A silicon carbide single crystal manufacturing device 1 as an embodiment of the present invention includes, as shown in Fig. 1, a crucible 2, a silica pipe 9, a support rod 10, a first heating coil 11, a second heating coil 12, and an interference preventing coil 13.

The crucible 2 includes a container member 3 and multiple guide members 8. The container member 3 includes a crucible main body 4 and a lid 6.

The crucible main body 4 is a cylindrical container made of graphite. The crucible main body 4 has an opening. The crucible main body 4 can house a silicon carbide raw material 5 which is a silicon carbide powder therein through the opening.

The lid 6 is made of graphite. The lid 6 has a disc shape. One surface of the lid 6 has a protruding shape. On a tip of the protruding portion, a silicon carbide seed crystal 7 is attached. The lid 6 can close the opening of the crucible main body 4 while the silicon carbide seed crystal 7 and the silicon carbide raw material 5 face each other. The seed crystal 7 has a disc shape.

The guide members 8 are made of graphite. Multiple guide members 8 are provided at intervals inside the crucible main body 4. Each of the guide members 8 has a shape obtained by cutting off a top end portion of a surface of a cone along a plane perpendicular to a perpendicular line extending from the apex of the cone to the bottom surface of the cone. Accordingly, a circular opening is formed at an upper end portion of each of the guide members 8. The diameter of the upper end portion of each of the guide members 8 is the same as the diameter of the seed crystal 7. Further, all the guide members 8 have the same shape. Accordingly, when the multiple guide members 8 are arranged inside the crucible main body 4, a columnar space is formed with the openings at the upper end portions of the guide members 8. In this space, the silicon carbide raw material 5 and the seed crystal 7 face each other.

A sublimed gas of the silicon carbide raw material 5 is guided by an inner surface (a surface facing the silicon carbide raw material 5) of each of the guide members 8 to the silicon carbide seed crystal 7. Further, a silicon carbide single crystal grows on the inner surfaces 14 of the guide members 8. The detail will be described below. Hereinafter, the guide members 8 are also referred to as, from the top, a guide member 8-1, a guide member 8-2, a guide member 8-3, and a guide member 8-4.

The silica pipe 9 houses therein the crucible main body 2 and the lid 5. Inside the silica pipe 9, an argon gas atmosphere is achieved after the crucible 2 is introduced therein. The support rod 10 is provided inside the silica pipe 9. The support rod 10 supports the crucible main body 2 inside the silica pipe 9.

The first heating coil 11, the second heating coil 12, and the interference preventing coil 13 are apart from each other at certain intervals. There are certain gaps between the silica pipe 9 and each of the first heating coil 11, the second heating coil 12 and the interference preventing coil 13. The first heating coil 11, the second heating coil 12 and the interference preventing coil 13 are wound around an external surface of the silica pipe 9.

The second heating coil 12 is arranged at a position which is outside of the silica pipe 9 and corresponds to the vicinity of the silica carbide raw material 5, with the crucible 2 having introduced into the silica pipe 9. The second heating coil 12 is arranged in order to adjust the temperature of the silicon carbide raw material 5.

The first heating coil 11 is arranged at a position which is outside of the silica pipe 9 and corresponds to the vicinity of the seed crystal 7, with the lid 6 having introduced into the silica pipe 9. The first heating coil 11 is arranged in order to adjust the temperature of the seed crystal 7.

The interference preventing coil 13 is provided between the first heating coil 11 and the second heating coil 12. The interference preventing coil 13 is configured to prevent the first heating coil 11 and the second heating coil 12 from interfering each other. In other words, the interference preventing coil 13 is configured, when an electric current goes through one of the first heating coil 11 and the second heating coil 12, to reduce the effect of a magnetic field generated from the one heating coil on the other heating coil.

Next, a manufacturing method according to the first embodiment will be described based on the flowchart illustrated in Fig. 2.

In Step S1, the silicon carbide raw material 5 which is a silicon carbide powder is supplied into the crucible main body 4.

In Step S2, the seed crystal 7 is attached to the lid 6. This lid 6 closes the opening of the crucible main body 4 with the seed crystal 7 facing the silicon carbide raw material 5.

In Step S3, the crucible 2 is introduced into the silica pipe 9, and fixed with the support rod 10. This state is illustrated in Fig. 1. Further, the inner pressure of the silica pipe 9 is set to 10 Torr, and an argon gas atmosphere is achieved.

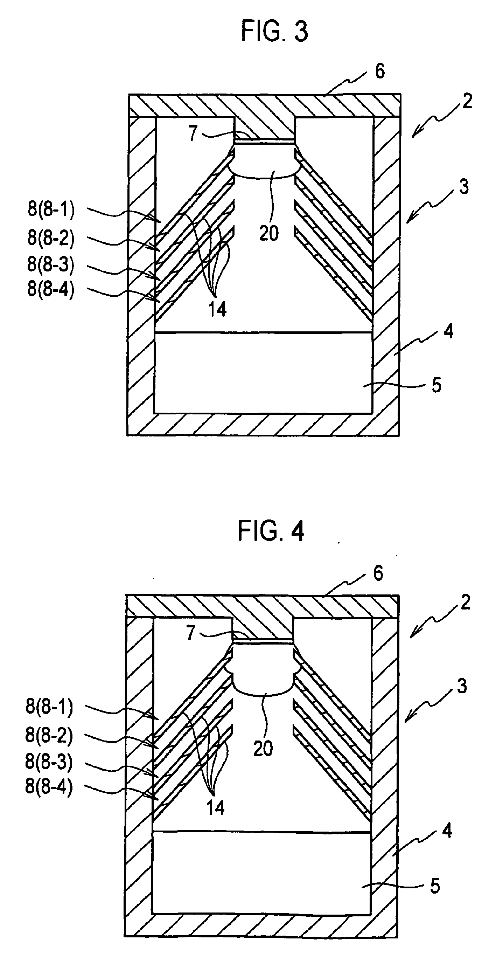

In Step S4, the first heating coil 11 and the second heating coil 12 are heated to achieve the temperature of the seed crystal 7 of 2300 degrees (the temperature for recrystallization of silicon carbide) and the temperature of the crucible main body 4 of 2400 degrees (the temperature for sublimation of the silicon carbide raw material 5). This state is maintained for 50 hours. This allows sublimation of the silicon carbide raw material 5, and a sublimed gas is guided by the inner surfaces 14 of the guide members 8 to the seed crystal 7. Then, a silicon carbide single crystal 20 is recrystallized (that is, grows) on the surface of the seed crystal 7 as shown in Figs. 3 and 4. Here, description will be given of how the silicon carbide single crystal 20 grows by referring to Figs. 3 to 5.

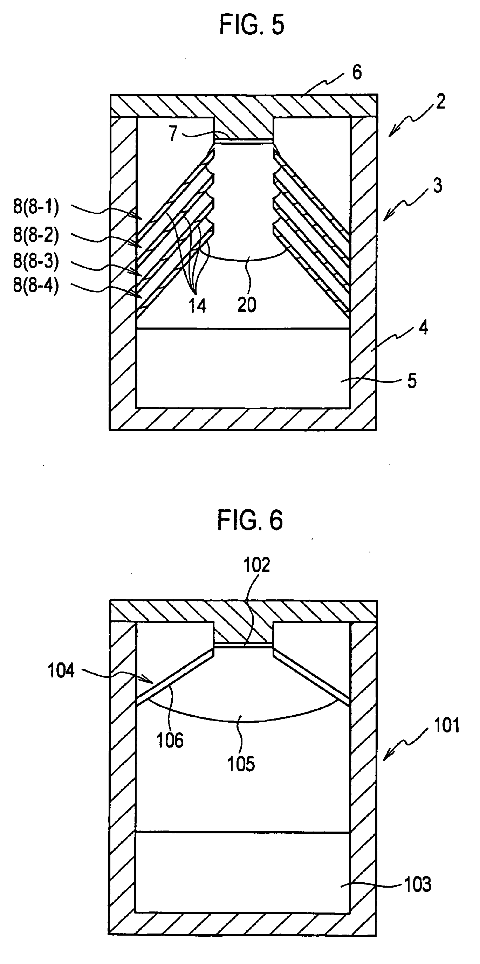

As shown in Fig. 3, once having reached an upper side portion of the guide member 8-1, the silicon carbide single crystal 20 grows in this upper end portion. Once having reached the inner surface 14 of the guide member 8-1, the silicon carbide single crystal 20 grows on this inner surface 14. Thereafter, once having reached an upper end portion of the guide member 8-2, the silicon carbide single crystal 20 hardly grows on the inner surface 14 of the guide member 8-1, but grows in the upper end portion of the guide member 8-2, as shown in Fig. 4. Once having reached the inner surface 14 of the guide member 8-2, the silicon carbide single crystal 20 grows on this inner surface 14. Thereafter, the silicon carbide single crystal 20 grows in a similar fashion. At the end, as shown in Fig. 5, the silicon carbide single crystal 20 grows on the inner surface 14 of the guide member 8-4. When the silicon carbide single crystal 20 has grown to a predetermined size on the inner surface 14 of the guide member 8-4, the process of Step S4 ends.

On the completion of the process of Step S4, the contact area between the silicon carbide single crystal 20 and the inner surface 14 of the guide member 8-4 is smaller than the contact area between the guide member and the inner surface upon the completion of the growth of a silicon carbide single crystal in a conventional manufacturing method.

Fig. 6 shows a silicon carbide single crystal 105 grown in a conventional manufacturing method. Herein, the conventional manufacturing method will be described briefly. In the conventional manufacturing method, firstly, a silicon carbide seed crystal 102 and a silicon carbide raw material 103 are arranged at respective positions facing each other inside a container member 101. The container member 101, the seed crystal 102 and the silicon carbide raw material 103 are those equivalent to the container member 3, the seed crystal 7 and the silicon carbide raw material 5, respectively.

Inside the container member 101, only one guide member 104 is provided. The guide member 104 is made of graphite. The guide member 104 has a shape obtained by cutting off a top end portion of a surface of a cone along a plane perpendicular to a perpendicular line extending from the apex of the cone to the bottom of the cone. Accordingly, a circular opening is formed at the upper end portion of the guide member 104. Although the shape of the guide member 104 and the shape of the guide member 8 are similar, the angle between the inner surface 106 and a perpendicular line of the surface of the seed crystal 102 is larger than the angle between the inner surface 14 of the guide member 8 and a perpendicular line of the surface of the seed crystal 7. In other words, the guide member 104 has a steeper angle than the guide member 8. Next, the same processes as Step S3 and Step S4 are performed. This allows recrystallization of a silicon carbide single crystal 105 on the inner surface 106 of the guide member 104.

Accordingly, the manufacturing method according to the present embodiment can provide the following advantageous effect compared to the conventional manufacturing method.

The manufacturing apparatus according to the present embodiment has the multiple guide members 8 at predetermined intervals from each other inside the crucible main body 4. Accordingly, a silicon carbide single crystal grown between the guide members 8 is not exposed to the silicon carbide raw material 5. Specifically, the area of the silicon carbide single crystal 20 exposed to the silicon carbide raw material 5 (hereinafter, also referred to as an "exposure area of the silicon carbide single crystal 20") is suppressed to an area comparable in size to each of the opening surfaces at the upper end portions of the guide members 8 during the growth of the silicon carbide single crystal 20.

On the other hand, the conventional manufacturing apparatus is provided with only one guide member 104. Accordingly, the exposure area of the silicon carbide single crystal 105 is comparable in size to the area of the opening surface at the upper portion of the guide member 104 when the silicon carbide single crystal 105 has reached the inner surface 106 of the guide member 104. Then, the exposure area of the silicon carbide single crystal 105 becomes larger as the silicon carbide single crystal 105 grows.

Accordingly, the exposure surface of the silicon carbide single crystal 20 during the growth of the silicon carbide single crystal 20 is smaller than the exposure area of the silicon carbide single crystal 105 during the growth of the silicon carbide single crystal 105.

Accordingly, the manufacturing method according the present embodiment can make the exposure area of the silicon carbide single crystal 20 smaller than the exposure area of the silicon carbide single crystal 105. Therefore, compared to the conventional manufacturing method, the area in which the silicon carbide single crystal and the silicon carbide raw material face each other can be smaller. Thus, the effect of heat radiation on the silicon carbide single crystal and the silicon carbide raw material from each other can be smaller.

This allows easier temperature control of the silicon carbide raw material than in the past. Specifically, it is easy to maintain the temperature of the silicon carbide raw material high. In addition, with the multiple guide members 8 provided at predetermined intervals, the heat insulating effect inside the container member 2 is improved. Thus, it is easy to maintain the inside of the container member 2 at a target temperature.

Further, in the manufacturing method according to the present embodiment, the silicon carbide single crystal 20 grows on and along the inner surface 14 of a first guide member 8 (the guide member 8-1, for example), reaches an upper end portion of the next guide member 8 (the guide member 8-2, for example), and then grows along the inner surface 14 of the guide member 8-2. Specifically, the silicon carbide single crystal 20 hardly grows on and along the inner surface 14 of the first guide member 8, but grows inside the columnar space. Accordingly, the contact area between the silicon carbide single crystal 20 and each of the guide members 8 is suppressed to a certain value or below. This value can be made smaller by narrowing the intervals among the guide members 8.

In the conventional manufacturing method, with only one guide member 104, the contact area between the silicon carbide single crystal 105 and the guide member 104 becomes larger as the silicon carbide single crystal 105 grows. On the other hand, the manufacturing method according to the present embodiment can make the contact area between the silicon carbide single crystal 20 and each of the guide members 8 smaller than that in the conventional manufacturing method. This allows the effect of thermal stress generated between the silicon carbide single crystal 20 and each of the guide members 8 to be smaller. Thus, the possibility of a crack occurring in the silicon carbide single crystal 20 can be reduced.

In addition, the conventional manufacturing method can make the contact area between the silicon carbide single crystal and the guide member smaller, thereby preventing a lowering in the temperature of the guide member. This can make the angle between the inner surface 14 of the guide member 8 and a horizontal surface smaller than the angle between the inner surface 106 of the guide member 104 and a horizontal surface. Accordingly, the manufacturing method according to the present embodiment allows a center portion, which is to be used as a product, to grow larger than that in the conventional manufacturing method.

As described above, the manufacturing method according to the present embodiment allows easier control on the temperature of the silicon carbide raw material 5 than that in the conventional manufacturing method, improving the quality of the silicon carbide single crystal 20. Therefore, a center portion of the silicon carbide single crystal 20 can grow larger.

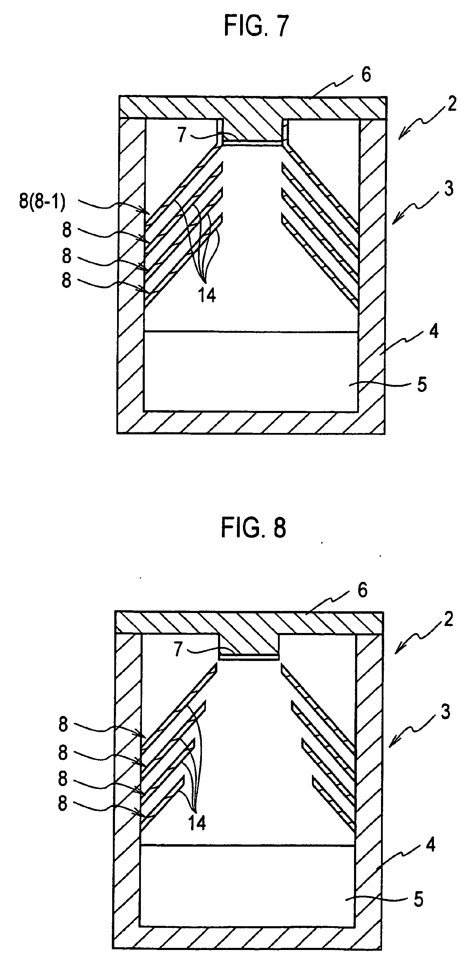

Figs. 7 to 12 show modification examples of the crucible 2. In the crucible 2 shown in Fig. 7, the guide member 8-1 is provided to the lid 6. An upper end portion of the guide member 8-1 is closely attached to a side surface of a protruding portion of the lid 6. In the crucible 2 shown in Fig. 8, the diameter of the upper end portion of the guide member 8 is larger for the guide member 8 located lower. Accordingly, a conical shape is formed by connecting upper end portions of the guide members 8.

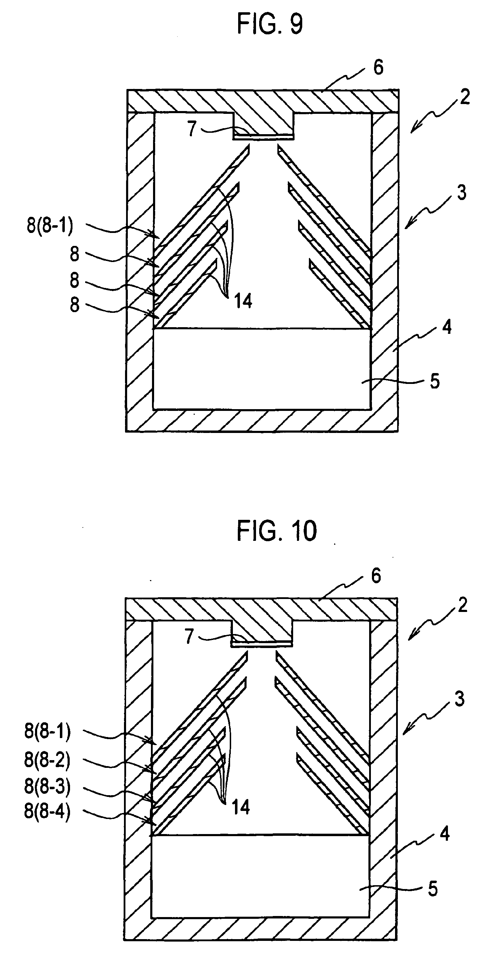

In the crucible 2 shown in Fig. 9, the diameter of the upper end portion of the guide member 8 is larger for the guide member 8 located lower. Accordingly, a conical shape is formed by connecting upper end portions of the guide members 8. In addition, the diameter of the upper end portion of the guide member 8-1 is smaller than the diameter of the seed crystal 7.

In the crucible 2 shown in Fig. 10, the diameter of the upper end portion of the guide member 8-1 and the diameter of the upper end portion of the guide member 8-2 are the same, and the diameter of the upper end portion of the guide member 8-3 and the diameter of the upper end portion of the guide member 8-4 are the same. Moreover, the diameter of the upper end portion of the guide member 8-3 is larger than the diameter of the upper end portion of the guide member 8-1. In addition, the diameter of the upper end portion of the guide member 8-1 is smaller than the diameter of the seed crystal.

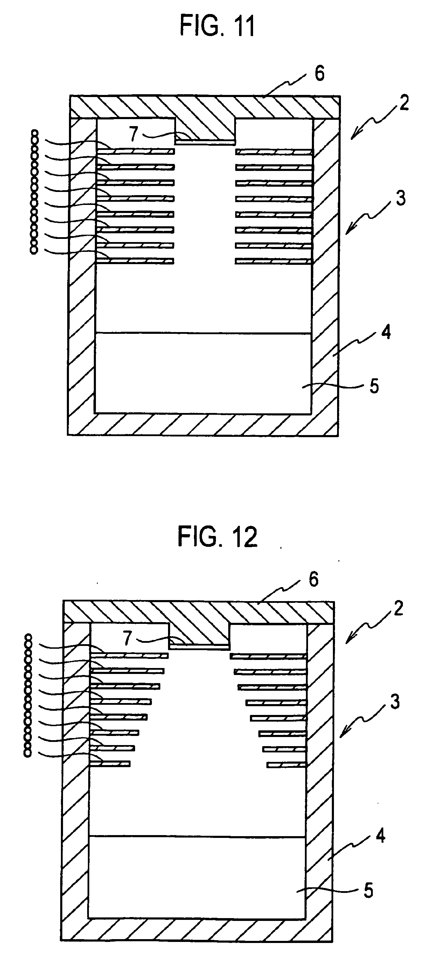

In the crucible 2 shown in Fig. 11, each of the guide members 8 has a flat plate shape. Each of the guide members 8 is provided with a circular opening portion formed at a position corresponding to the seed crystal 7. The diameter of the opening portion is the same as the diameter of the seed crystal 7. A columnar space is formed by connecting these opening portions.

In the crucible 2 shown in Fig. 12, each of the guide members 8 has a flat plate shape. Each of the guide members 8 is provided with a circular opening portion formed at a position corresponding to the seed crystal 7. The diameter of the opening portion disposed at the uppermost stage is same as the diameter of the seed crystal 7. The diameter of the opening portion is larger for the guide member 8 provided at a lower position. Accordingly, a conical space is formed by connecting these holes. With these modification examples, the above-described effects can be obtained.

### (Other modification example)

In the above-described manufacturing method, the silicon carbide raw material 5 may be changed to a powder of GaN or AlN, and the seed crystal 7 may be changed to a seed crystal of GaN or AlN. According to this modification example, the above-described effects can be obtained, and further, a single crystal of GaN or AlN can be grown.

Hereinabove, the embodiments to which the present invention made by the present inventors is applied has be described. However, the present invention is not limited by the description and drawings which constitute part of the disclosure of the present invention according to these embodiments.

It should be noted that the entire contents of Japanese Patent Application No. 2008-129187 (filed on May 16, 2008) are incorporated into the present description by reference.

### INDUSTRIAL APPLICABILITY

As described above, the single crystal manufacturing device and manufacturing method according to the present invention allow easier control on the temperature of a raw material for single crystal growth than in the past. Therefore, the quality of a single crystal can be improved. Further, the growth of a center portion of a single crystal can be facilitated. Thus, the single crystal manufacturing device and manufacturing method according to the present invention is useful in the field of single crystal manufacturing.

### EXPLANATION OF REFERENCE NUMERALS

1: silicon carbide single crystal manufacturing device
2: crucible
3: container member
4: crucible main body
5: silicon carbide raw material
6: lid
7: silicon carbide seed crystal
8: guide member
9: silica pipe
10: support rod
11: first heating coil
12: second heating coil
13: interference preventing coil
14: inner surface

## Claims

1. A single crystal manufacturing device (1), including:
a container member (3) configured to house a raw material for single crystal growth (5) and a seed crystal for single crystal growth (7) in such a manner that the raw material for single crystal growth (5) and the seed crystal for single crystal growth (7) face each other, the raw material for single crystal growth (5) being used as a single crystal raw material, a sublimed gas produced by sublimation of the raw material for single crystal growth (5) recrystallizing on the seed crystal for single crystal growth (7), and
**characterized by**:
a plurality of guide members (8) provided inside the container member (3), wherein the guide members (8) each have an opening portion formed therein at a position corresponding to the seed crystal for single crystal growth (7), and are provided at intervals between the raw material for single crystal growth (5) and the seed crystal for single crystal growth (7).

2. The single crystal manufacturing device according to claim 1, wherein
an inside of the container member (3) has a shape of a column,
the guide members (8) each have a shape of a cone,
a diameter of a bottom surface of the cone is substantially identical to an inner diameter of the container member (3), and
an opening portion is formed at an upper end portion of each of the guide members (8), the opening portion being formed by cutting off an upper end portion of a surface of the cone along a plane perpendicular to a perpendicular line extending from an apex of the cone to the bottom surface of the cone

3. The single crystal manufacturing device according to claim 2, wherein
a diameter of the opening portion formed in each of the plurality of guide members (8) is increased toward a lower position in the container member (3).

4. The single crystal manufacturing device according to claim 1, wherein
an inside of the container member (3) has a shape of a column,
the guide members (8) each have a shape of a flat plate, and
an opening portion is formed at the position corresponding to the seed crystal for single crystal growth (7) in each of the plurality of guide members (8).

5. The single crystal manufacturing device according to claim 4, wherein
a diameter of the opening portion formed in each of the plurality of guide members (8) is increased toward a lower position in the container member (3).

6. The single crystal manufacturing device according to claim 1, wherein
a single crystal is formed by recrystallization of a sublimed gas, which is produced by sublimation of the raw material for single crystal growth (5), on a surface of the seed crystal for single crystal growth (7), and
the single crystal is selected from the group consisting of SiC, GaN, and AlN.

7. A single crystal manufacturing method,
**characterized by**:
housing a raw material for single crystal growth (5) and a seed crystal for single crystal growth (7) at respective positions facing each other inside a container member (3), and arranging a plurality of guide members (8) which each have an opening portion formed therein at a position corresponding to the seed crystal for single crystal growth (7), at intervals between the raw material for single crystal growth (5) and the seed crystal growth (7), and
subliming the raw material for single crystal growth (5), guiding a sublimed gas of the raw material for single crystal growth (5) by the plurality of guide members (8) to the seed crystal for single crystal growth (7) and growing a single crystal on surfaces of the plurality of guide members (8).

8. The single crystal manufacturing method according to claim 7, wherein the single crystal is selected from the group consisting of SiC, GaN and AlN.

## Patentansprüche

1. Vorrichtung (1) zur Herstellung eines Einkristalls, die umfasst:
ein Behälterteil (3), das ausgebildet ist, um ein Rohmaterial für die Einkristallzüchtung (5) und einen Keimkristall für die Einkristallzüchtung (7) in einer derartigen Weise aufzunehmen, dass das Rohmaterial für die Einkristallzüchtung (5) und der Keimkristall für die Einkristallzüchtung (7) zueinander hin liegen, wobei das Rohmaterial für die Einkristallzüchtung (5) als ein Rohmaterial für den Einkristall verwendet wird, wobei sich ein sublimiertes Gas, das durch Sublimation des Rohmaterials für die Einkristallzüchtung (5) erzeugt wird, auf dem Keimkristall für die Einkristallzüchtung (7) rekristallisiert, und
**gekennzeichnet durch**
eine Vielzahl von Führungselementen (8), die innerhalb des Behälterteils (3) vorhanden sind, wobei die Führungselemente (8) jeweils einen darin ausgebildeten Öffnungsabschnitt in einer Position entsprechend dem Keimkristall für die Einkristallzüchtung (7) aufweisen und in Intervallen zwischen dem Rohmaterial für die Einkristallzüchtung (5) und dem Keimkristall für die Einkristallzüchtung (7) vorhanden sind.

2. Vorrichtung zur Herstellung eines Einkristalls nach Anspruch 1, bei der
eine Innenseite des Behälterteils (3) eine Form einer Säule aufweist,
die Führungselemente (8) jeweils eine Form eines Kegels aufweisen,
ein Durchmesser einer Bodenfläche des Kegels im Wesentlichen identisch mit einem Innendurchmesser des Behälterteils (3) ist, und
ein Öffnungsabschnitt in einem oberen Endabschnitt eines jeden der Führungselemente (8) ausgebildet ist, wobei der Öffnungsabschnitt durch Wegschneiden eines oberen Endabschnittes einer Fläche des Kegels längs einer Ebene senkrecht zu einer senkrechten Linie gebildet wird, die sich von einer Spitze des Kegels bis zur Bodenfläche des Kegels erstreckt.

3. Vorrichtung zur Herstellung eines Einkristalls nach Anspruch 2, bei der
ein Durchmesser des Öffnungsabschnittes, der in einem jeden der Vielzahl der Führungselemente (8) gebildet wird, in Richtung einer unteren Position im Behälterteil (3) vergrößert wird.

4. Vorrichtung zur Herstellung eines Einkristalls nach Anspruch 1, bei der
eine Innenseite des Behälterteils (3) eine Form einer Säule aufweist,
die Führungselemente (8) jeweils eine Form einer flachen Platte aufweisen, und
ein Öffnungsabschnitt in der Position gebildet wird, die dem Keimkristall für die Einkristallzüchtung (7) in jedem der Vielzahl von Führungselementen (8) entspricht.

5. Vorrichtung zur Herstellung eines Einkristalls nach Anspruch 4, bei der
ein Durchmesser des Öffnungsabschnittes, der in einem jeden der Vielzahl der Führungselemente (8) gebildet wird, in Richtung einer unteren Position im Behälterteil (3) vergrößert wird.

6. Vorrichtung zur Herstellung eines Einkristalls nach Anspruch 1, bei der
ein Einkristall durch Rekristallisation eines sublimierten Gases gebildet wird, das durch Sublimation des Rohmaterials für die Einkristallzüchtung (5) auf einer Oberfläche des Keimkristalls für die Einkristallzüchtung (7) erzeugt wird, und
der Einkristall aus der Gruppe ausgewählt wird, die besteht aus: SiC, GaN und AlN.

7. Verfahren zur Herstellung eines Einkristalls,
**gekennzeichnet durch** die folgenden Schritte:
Aufnehmen eines Rohmaterials für die Einkristallzüchtung (5) und eines Keimkristalls für die Einkristallzüchtung (7) in zueinander hin liegenden entsprechenden Positionen innerhalb eines Behälterteils (3) und Anordnen einer Vielzahl von Führungselementen (8), die jeweils einen darin ausgebildeten Öffnungsabschnitt in einer Position aufweisen, die dem Keimkristall für die Einkristallzüchtung (7) entspricht, in Intervallen zwischen dem Rohmaterial für die Einkristallzüchtung (5) und der Keimkristallzüchtung (7); und
Sublimieren des Rohmaterials für die Einkristallzüchtung (5), Führen eines sublimierten Gases des Rohmaterials für die Einkristallzüchtung (5) **durch** die Vielzahl der Führungselemente (8) zum Keimkristall für die Einkristallzüchtung (7) und Wachsenlassen eines Einkristalls auf Oberflächen der Vielzahl der Führungselemente (8).

8. Verfahren zur Herstellung eines Einkristalls nach Anspruch 7, bei dem der Einkristall aus der Gruppe ausgewählt wird, die besteht aus: SiC, GaN und AlN.

## Revendications

1. Dispositif de fabrication de monocristaux (1), comprenant :
un élément formant conteneur (3) configuré pour accueillir une matière première pour croissance monocristalline (5) et un cristal germe pour croissance monocristalline (7) de telle manière que la matière première pour croissance monocristalline (5) et le cristal germe pour croissance monocristalline (7) se font face l'un l'autre, la matière première pour croissance monocristalline (5) étant utilisée en tant que matière première de monocristal, un gaz sublimé produit par sublimation de la matière première pour croissance monocristalline (5) se recristallisant sur le cristal germe pour croissance monocristalline (7), et
**caractérisé par** :
une pluralité d'éléments de guidage (8) fournis à l'intérieur de l'élément formant conteneur (3), dans lequel les éléments de guidage (8) présentent respectivement une partie ouverture formée en leur sein au niveau d'une position correspondant au cristal germe pour croissance monocristalline (7), et sont fournis à des intervalles entre la matière première pour croissance monocristalline (5) et le cristal germe pour croissance monocristalline (7).

2. Dispositif de fabrication de monocristaux selon la revendication 1, dans lequel
un intérieur de l'élément formant conteneur (3) présente une forme de colonne,
les éléments de guidage (8) présentent respectivement une forme de cône,
un diamètre d'une surface basale du cône est essentiellement identique à un diamètre intérieur de l'élément formant conteneur (3), et
une partie ouverture est formée au niveau d'une partie extrémité supérieure de chacun des éléments de guidage (8), la partie ouverture étant formée par découpe d'une partie extrémité supérieure d'une surface du cône le long d'un plan perpendiculaire à une ligne perpendiculaire s'étendant à partir d'un sommet du cône vers la surface basale du cône.

3. Dispositif de fabrication de monocristaux selon la revendication 2, dans lequel
un diamètre de la partie ouverture formée dans chaque élément parmi la pluralité d'éléments de guidage (8) est augmenté en direction d'une position inférieure dans l'élément formant conteneur (3).

4. Dispositif de fabrication de monocristaux selon la revendication 1, dans lequel
un intérieur de l'élément formant conteneur (3) présente une forme de colonne,
les éléments de guidage (8) présentent respectivement une forme de plaque plate, et
une partie ouverture est formée au niveau de la position correspondant au cristal germe pour croissance monocristalline (7) dans chaque élément parmi la pluralité d'éléments de guidage (8).

5. Dispositif de fabrication de monocristaux selon la revendication 4, dans lequel
un diamètre de la partie ouverture formée dans chaque élément parmi la pluralité d'éléments de guidage (8) est augmenté en direction d'une position inférieure dans l'élément formant conteneur (3).

6. Dispositif de fabrication de monocristaux selon la revendication 1, dans lequel
un monocristal est formé par recristallisation d'un gaz sublimé, qui est produit par sublimation de la matière première pour croissance monocristalline (5), sur une surface du cristal germe pour croissance monocristalline (7), et
le monocristal est sélectionné parmi le groupe constitué de SiC, GaN et AIN.

7. Procédé de fabrication de monocristaux,
**caractérisé par** les étapes consistant à :
accueillir une matière première pour croissance monocristalline (5) et un cristal germe pour croissance monocristalline (7) au niveau de positions respectives se faisant face l'une l'autre à l'intérieur d'un élément formant conteneur (3), et agencer une pluralité d'éléments de guidage (8) qui présentent respectivement une partie ouverture formée en leur sein au niveau d'une position correspondant au cristal germe pour croissance monocristalline (7), à des intervalles entre la matière première pour croissance monocristalline (5) et le cristal germe pour croissance monocristalline (7), et
sublimer la matière première pour croissance monocristalline (5), guider un gaz sublimé de la matière première pour croissance monocristalline (5) grâce à la pluralité d'éléments de guidage (8) vers le cristal germe pour croissance monocristalline (7) et faire croître un monocristal sur des surfaces de la pluralité d'éléments de guidage (8).

8. Procédé de fabrication de monocristaux selon la revendication 7, dans lequel le monocristal est sélectionné parmi le groupe constitué de SiC, GaN et AIN.
